**Europäisches Patentamt**

**European Patent Office**

**Office européen des brevets**

(19)

(11) Veröffentlichungsnummer: **0 027 612**
**B1**

(12) # EUROPÄISCHE PATENTSCHRIFT

(45) Veröffentlichungstag der Patentschrift:
**29.12.82**

(21) Anmeldenummer: **80106164.9**

(22) Anmeldetag: **10.10.80**

(51) Int. Cl.³: **G 03 C 1/68,** C 08 L 53/02,
**G 03 F 7/10**

(54) **Fotopolymerisierbare Gemische und daraus hergestellte lichthärtbare Elemente.**

(30) Priorität: **18.10.79 DE 2942183**

(43) Veröffentlichungstag der Anmeldung:
**29.04.81 Patentblatt 81/17**

(45) Bekanntmachung des Hinweises auf die Patenterteilung:
**29.12.82 Patentblatt 82/52**

(84) Benannte Vertragsstaaten:
**BE CH DE FR GB IT LI NL SE**

(56) Entgegenhaltungen:
**DE-A-2 815 678**
**DE-A-2 939 989**
**DE-B-2 034 725**

(73) Patentinhaber: **BASF Aktiengesellschaft,**
**Carl-Bosch-Strasse 38, D-6700 Ludwigshafen (DE)**

(72) Erfinder: **Heinz, Gerhard, Dr., Im Vogelsang 2,**
**D-6719 Weisenheim (DE)**
Erfinder: **Richter, Peter, Dr., Bensheimer Ring 24,**
**D-6710 Frankenthal (DE)**
Erfinder: **Jun, Mong-Jon, Dr., Maulbeerstueck 20,**
**D-6720 Speyer (DE)**

Fotopolymerisierbare Gemische und daraus hergestellte lichthärtbare Elemente

Die Erfindung betrifft vorteilhafte, fotopolymerisierbare Gemische zur Herstellung von lichthärtenden Klebstoffen weichelastischen Folienbahnen und Reliefformen auf Basis einer Fotoinitiator enthaltenden Mischung von äthylenisch ungesättigten Monomeren mit einem elastomeren Dien-Blockcopolymerisat der Struktur ABC.

Fotopolymerisierbare Gemische für die Herstellung von Formteilen wie Reliefformen für den Flexodruck sind an sich bekannt und z. B. in den DE-A-2 138 582, 2 215 090, 2 223 808, 2 364 873, 2 610 206, 2 631 837, 2 720 228, 2 815 678 und in den US-Patentschriften 2 948 611, 3 024 180, 3 674 486, 3 798 035 und 3 951 657 beschrieben. Die bekannten Gemische befriedigen jedoch in der Praxis manche Ansprüche nicht. So weist ein Teil der daraus hergestellten Reliefformen ungenügende Flexibilität und Elastizität sowie zu hohe Härte auf, andere neigen bei höherer Scherbeanspruchung, erhöhtem Anpreßdruck und schneller dynamischer Beanspruchung zu plastischen Deformationen und zu »kaltem Fließen«, womit sie sich in negativer Weise von den Eigenschaften von vulkanisiertem Kautschuk bei herkömmlichen Gummiklischees unterscheiden. Ein anderer Teil der daraus hergestellten Reliefformen weist nur eine begrenzte Beständigkeit gegenüber bestimmten Lösungsmitteln in Flexofarben auf. Aus den DE-A-2 215 090, 2 223 808, 2 815 678, 2 610 206 ist bekannt, als Polymere in den fotopolymerisierbaren Gemischen für reliefbildende Schichten elastomere Blockcopolymere vom Typ A-B-A zu verwenden, die zwischen zwei thermoplastischen nicht-elastomeren Polymerblöcken einen elastomeren Polymerblock aufweisen wie die Styrol-Isopren-Styrol- oder Styrol-Butadien-Styrol-Dreiblockcopolymeren. Der Nachteil der Verwendung dieser Blockcopolymeren liegt nicht nur in der Schwierigkeit ihrer Herstellung mit stets genau reproduzierbaren Eigenschaften, sondern auch in dem häufigen Auftreten starker Trübungen sowohl der Lösungen der fotopolymersierbaren Gemische zur Herstellung der fotopolymersierbaren Schichten als auch der unbelichteten Gemische in den Schichten selbst. Trübungen der lichtempfindlichen Schichten führen bekanntlich zu Lichtstreueffekten, die die Wiedergabequalität der fotografischen Vorlage auf der fertigen Druckform stark beeinträchtigen. Insbesondere werden öfter sogenannte negative Bildelemente (Negativschriften und Näpfchen) nicht ausreichend ausgebildet und die Flanken von Reliefteilen tonnenförmig verzerrt, was zu Tonwertveränderungen beim Druckprozeß führt.

Der vorliegenden Erfindung lag die Aufgabe zugrunde, geeignete fotopolymerisierbare Gemische für die Herstellung von insbesondere Reliefformen für den Flexodruck zu finden, die die Nachteile der herkömmlichen lichtempfindlichen Schichten in zumindest geringerem Umfang aufweisen, deren Basispolymere einfach und wirtschaftlich mit gut reproduzierbaren Eigenschaften herstellbar sind, aus denen fotopolymerisierbare Schichten nach bekannten, dem Stand der Technik entsprechenden Verarbeitungsmethoden durch Gießen, Pressen und Extrudieren hergestellt werden können, die im unvernetzten Zustand in üblichen Entwicklungslösungsmitteln gut löslich sind und deren daraus nach Belichten und Auswaschen gebildete Reliefdruckformen vorlagengetreue Drucke liefern und hohe Auflagenfestigkeit und gute Beständigkeit gegen die üblichen Farblösemittel haben.

Es wurde nun gefunden, daß fotopolymerisierbare Gemische, enthaltend

a) wenigstens 40 Gew.-% mindestens eines in einem Entwicklerlösungsmittel löslichen elastomeren Blockcopolymerisats mit einem thermoplastischen nicht-elastomeren Polymerblock A und einem elastomeren Dien-Polymerblock B

b) wenigstens 1 Gew.-% mindestens eines mit dem Blockcopolymerisat (a) verträglichen fotopolymersierbaren olefinisch ungesättigten Monomeren und

c) 0,1 bis 10 Gew.-% mindestens eines Fotopolymerisationsinitiators,

die gewünschten Eigenschaften dann aufweisen, wenn das Blockcopolymerisat (a) ein elastomeres Blockcopolymerisat der Struktur A-B-C ist, wobei

a1) der 5 bis 25 Gew.-% und bevorzugt 7 bis 20 Gew.-% des Blockcopolymerisats ausmachende Polymerblock A aus mindestens einem der Styrol-Monomeren der Formel $CH_2 = CRR'$ mit $R = $ Wasserstoff oder Methyl, $R' = $ Phenyl oder $C_1 - C_4$-alkylsubstituiertes Phenyl hergestellt ist und eine Einfriertemperatur über $+25°C$ hat,

a2) der 15 bis 90 Gew.-% des Blockcopolymerisats ausmachende Polymerblock B aus mindestens einem aliphatischen Dienkohlenwasserstoff mit 4 bis 5 C-Atomen hergestellt ist und eine Einfriertemperatur unter $-20°C$ hat, und

a3) der 5 bis 60 Gew.-% des Blockcopolymerisat ausmachende Polymerblock C durch Homo- oder Copolymerisation mindestens eines aliphatischen Dienkohlenwasserstoffs mit 4 bis 5 C-Atomen hergestellt ist und eine Einfriertemperatur zwischen $-30°C$ und $+15°C$ und bevorzugt zwischen $-20°C$ und $+10°C$ hat.

Erfindungsgemäße fotopolymerisierbare Gemische mit den spezifischen Dreiblockcopolymeren zeigen bei ihrer praktischen Anwendung eine Reihe von Vorteilen. Gegenüber ähnlichen handelsüblichen Dreiblockcopolymeren A-B-A sind die erfindungsgemäß einzusetzenden Polymeren in ihren toluolischen Lösungen glasklar und von geringer Eigenabsorption im Wellenlängenbereich von 300 bis 400 µm. Das gleiche gilt für daraus hergestellte Filme, die keine Trübung zeigen, was insbesondere für die Herstellung von fotopolymeren Reliefdruckformen von großer Wichtigkeit ist. Getrübte, lichtstreuende Polymerfilme in fotopolymerisierbaren Schichten verhindern die Ausbildung glatter, scharfer Kanten der Reliefteile an der Grenze zwischen belichteten und unbelichteten Segmenten und führen statt dessen zu tonnenförmigen Auswölbungen der Reliefflanken mit der Folge, daß es im Druckprozeß zu unscharfen Abbildungen, zu Verbreiterungen der druckenden Oberflächen und damit zu Tonwertverschiebungen kommt. Negative Bildelemente, d. h. in Vollflächen ausgesparte Linien, Schriften oder Bildteile schmieren mit Druckfarbe zu und sind als solche im Druckbild nicht mehr erkenntlich. Die außerordentliche Klarheit von Schichten aus erfindungsgemäßen fotopolymerisierbaren Gemischen mit den spezifischen Blockcopolymeren hat weiterhin den Vorteil, daß daraus hergestellte Reliefdruckformen von sehr großen Relieftiefen mit geradem Flankenaufbau herstellbar sind, was für den Bereich des Bedruckens rauher und welliger Oberflächen wie Wellpappe, Kartonagen und Servietten erforderlich ist. Reliefhöhen von über 3 mm sind ohne Probleme wie bei konventionell geprägten Gummiklischees herstellbar, ohne daß es in der Tiefe der Reliefteile zum Zupolymerisieren kommt. Es ist von Vorteil, daß bei den Blockcopolymeren der erfindungsgemäßen fotopolymerisierbaren Gemische die Struktur A-B-C eine ausgezeichnete Anpassung der Polymerstruktur an die gewünschten mechanischen Eigenschaften in der fotovernetzten Schicht zuläßt. So sind für die Verwendung erfindungsgemäßer Gemische in der Herstellung von Unterschichten für Mehrschichtenplatten Polymere bevorzugt, die bei einer niedrigen Viskositätszahl einen kurzen Block C aus einem statistischen Isopren-Styrol-Copolymerisat aufweisen und aufgrund ihrer niedrigen Schmelzviskosität sehr vorteilhaft durch Extrudieren, Kalandrieren oder Pressen zu verarbeiten sind. Die spezifischen Blockcopolymeren der erfindungsgemäßen Mischungen zeigen zudem eine gute Dosierbarkeit in Krümelform, was für die Beschickung von Extrudern von großem Vorteil ist und eine Mitverwendung von Trennmitteln nicht erforderlich macht.

Das erfindungsgemäß einzusetzende elastomere Blockcopolymerisat hat die Struktur A-B-C, wobei A, B und C verschiedenartige, chemisch miteinander verknüpfte Polymerblöcke darstellen. Zum Aufbau des Blockcopolymerisats ist folgendes zu sagen:

Als Styrol-Monomere der Formel $CH_2 = CRR'$ mit den angegebenen Bedeutungen für R und R' sind z. B. α-Methylstyrol, Vinyltoluole, tert.

Butylstyrol und insbesondere Styrol selber geeignet. Der Polymerblock A ist vorzugsweise ein Homo- oder Copolymerisat-Block aus den genannten Styrol-Monomeren, insbesondere aber ein Polystyrol-Block.

Als aliphatische Dienkohlenwasserstoffe mit 4 bis 5 C-Atomen sind Butadien und Isopren bevorzugt. Für die Herstellung des Polymerblocks B können die Dienkohlenwasserstoffe allein oder in Mischung miteinander eingesetzt werden. Vorzugsweise ist der Polymerblock B somit ein Homopolymerisat-Block des Butadien, ein Homopolymerisat-Block des Isoprens oder ein statistischer Copolymerisat-Block aus Butadien und Isopren.

Der 5 bis 60 Gew.-% des Blockcopolymerisats A-B-C ausmachende Block C stellt einen Homo- oder Copolymerisat-Block mit einer Einfriertemperatur von +15°C bis −30°C, vorzugsweise +10°C bis −20°C dar. Als geeignete Homopolymerisat-Blöcke sind hierfür beispielsweise seien Polybutadien-Blöcke mit mehr als 70 Gew.-% 1,2 Konfiguration und Polyisopren-Blöcke mit mehr als 40 Gew.-% 3,4-Konfiguration zu nennen, die bevorzugt ein mittleres Molekulargewicht von 10 000 bis 90 000 haben.

In einer weiteren Ausführungsart kann Block C ein statistisches Copolymerisat aus den aliphatischen Dienkohlenwasserstoffen mit 4 bis 5 C-Atomen, wie Butadien oder Isopren, und den Styrol-Monomeren der Formel $CH_2 = CRR'$ wie den vorgenannten, sein, wobei der Anteil der im Block C einpolymerisierten Dienkohlenwasserstoffe zweckmäßig 70 bis 30 Gew.-%, insbesondere 60 bis 30 Gew.-%, der Anteil der im Block C einpolymeriserten Styrol-Monomeren zweckmäßig 30 bis 70 Gew.-%, insbesondere 40 bis 70 Gew.-%, bezogen auf den Block C, beträgt und durch die geforderte Einfriertemperatur begrenzt wird, die für das statistische Copolymerisat bevorzugt zwischen −20°C und +10°C liegt. Der Gesamtanteil des Blocks C am Blockcopolymerisat A-B-C liegt für den Fall eines derartigen Copolymeren vorzugsweise zwischen 5 bis 35 Gew.-%, bezogen auf das Blockcopolymerisat A-B-C.

Für bestimmte Anwendungszwecke und verbesserte Oxidations- und Alterungsbeständigkeit können die beschriebenen Blockcopolymeren teilweise, insbesondere selektiv hydriert werden.

Sehr geeignete Blockcopolymerisate A-B-C für die erfindungsgemäßen Gemische haben, gemessen als 0,5gewichtsprozentige Lösungen in Toluol bei 25°C, Viskositätszahlen von etwa 60 bis 350 ml/g und insbesondere 90 bis 180 ml/g, was einem Bereich eines mittleren Molekulargewichts $\overline{M}_v$ von etwa 100 000 bis 200 000 entspricht.

Blockcopolymerisate der vorgenannten Art können durch sequentielle, anionische Polymerisation in an sich bekannter und üblicher Weise hergestellt werden.

Je nach speziellem Anwendungszweck ist es natürlich auch möglich, Gemische von Blockcopolymerisation der genannten Art zu verwenden bzw. sie mit untergeordneten Mengen an anderen verträglichen Polymeren und insbesondere an Elastomeren abzumischen.

Die für die erfindungsgemäßen fotopolymerisierbaren Gemische und damit hergestellten lichthärtbaren Elemente genannten spezifischen Blockcopolymeren A-B-C zeigen aufgrund ihrer Struktur keine oder nur eine geringe physikalische Vernetzung, was aus der geringen Härte und der beträchtlichen plastischen Deformierbarkeit hervorgeht. Recht geeignet sind Blockcopolymere A-B-C, deren Polymerblock C mit dem Polymerblock A unverträglich ist. Durch Belichten von Schichten, die die erfindungsgemäßen fotopolymerisierbaren Gemische (mit Monomeren und Fotoinitiator) enthalten, werden die mechanischen Eigenschaften so verbessert, daß sie denen von vulkanisiertem Kautschuk gleichen und somit beispielsweise als Reliefdruckform für den Flexodruck ausgezeichnet geeignet sind. Durch die fotochemische Vernetzung ist ein Anstieg der Härte zu verzeichnen, wobei durch Auswahl der Menge, Art und Funktionalität der zugesetzten Monomeren sowie durch die Belichtungsintensität die gewünschten Härteeinstellungen in weitem Maße variiert werden können. Gleichzeitig steigt die Kautschukelastizität, gemessen z. B. als Rückprallelastizität der vernetzten, belichteten Schichten, gegenüber den unvernetzten deutlich an, so daß in der Praxis kein Unterschied im Rückstellvermögen und Deformationsverhalten zu konventionell vulkanisiertem Kautschuk in Form von Reliefdruckformen gefunden werden kann. Zur Handhabung unvernetzter, unbelichteter Schichten aus den erfindungsgemäßen Gemischen ist es natürlich sinnvoll, Gemische zusammenzustellen, deren kaltes Fließen bzw. deren Neigung zu plastischer Deformation dem Anwendungszweck angepaßt ist. Beispielsweise wird für die Verwendung bei der Herstellung von Druckplatten ein erfindungsgemäßes Gemisch mit einem Blockcopolymerisat einer Viskositätszahl von bis zu 110 ml/g mit einem Monomergehalt von vorzugsweise 5 bis 20 Gew.-% besonders geeignet sein. Dabei können Härte, Rückprallelastizität, Elastizitätsmodul und das Spannungs-Dehnungs-Verhalten über die Blocklänge der Blöcke A, B und C im Blockcopolymerisat und deren chemische Zusammensetzung in zusätzlicher Weise beliebig gesteuert werden. Hohe Härtewerte bei niedrigen Viskositätszahlen werden für Schichten aus fotopolymerisierbaren Gemischen erhalten, wenn die Blocklänge A und C im Blockpolymerisat stark erhöht wurde oder bei denen im Blockcopolymerisat der Block B Butadien statt Isopren enthält.

Sehr geeignete erfindungsgemäße fotopolymerisierbare Gemische enthalten 60 bis 99 Gew.-% und insbesondere 70 bis 95 Gew.-% des Blockcopolymerisats (a) und 1 bis 40 und insbesondere 5 bis 30 Gew.-% an Monomeren. Als mit dem Blockcopolymerisat verträgliche Monomere mit mindestens einer polymerisierbaren C—C-Doppelbindung seien besonders genannt die Ester der Acrylsäure und/oder Methacrylsäure mit ein- oder mehrwertigen Alkoholen, wie Butylacrylat, Butylmethacrylat, 2-Äthylhexylacrylat, Laurylacrylat, Laurylmethacrylat, Äthylenglykoldimethacrylat, Butandiol-1,4-diacrylat, Butandiol-1,4-dimethacrylat, Neopentylglykoldimethacrylat, 3-Methylpentandioldiacrylat, 2-Hydroxypropylacrylat, 2-Hydroxyäthylmethacrylat, Hexandioldiacrylat, Hexandiol-1,6-dimethacrylat, 1,1,1-Trimethylolpropantriacrylat und -trimethacrylat, Di-, Tri- und Tetraäthylenglykoldiacrylat, Tripropylenglykoldiacrylat, Pentaerythrittetracrylat. Geeignet sind auch Vinylester aliphatischer Monocarbonsäuren wie Vinyloleat und Vinyläther von Alkoholen wie Octadecylvinyläther oder Butandiol-1,4-divinyläther. Durch geeignete Wahl der Monomeren und Mischungen von ihnen können die Eigenschaften der erfindungsgemäßen fotopolymerisierbaren Gemische für den speziellen Zweck modifiziert werden.

Das fotopolymerisierbare Gemisch enthält ferner einen oder ein Gemisch von Fotoinitiatoren in einer Menge von 0,01 bis 10 Gew.-%, insbesondere von 0,1 bis 5 Gew.-%, z. B. Benzoin; Benzoinderivate, wie dessen Methyl-, Isopropyl-, n-Butyl oder Isobutyläther; symmetrisch oder unsymmetrisch substituierte Benzilketale, wie Benzildimethylketal, oder andere bekannte Fotoinitiatorsysteme.

Zur Verhinderung von thermischer Polymerisation der Monomeren können die erfindungsgemäßen Gemische Inhibitoren wie p-Methoxyphenol, Hydrochinon, 2,6-Di-tert.butylparakresol oder andere handelsübliche Inhibitoren enthalten. Voraussetzung für die Auswahl derartiger Inhibitoren ist das Fehlen einer nennenswerten Eigenabsorption im aktinischen Bereich, in dem der gleichzeitig verwendete Fotoinitiator absorbiert. Insbesondere bei erfindungsgemäßen Gemischen mit Blockcopolymerisaten A-B-C mit vorwiegend oder ganz Polybutadien enthaltenden Polymerblöcken B ist die Verwendung von Inhibitoren empfehlenswert, die als Antioxidans gegen einen oxidativen Kautschukabbau wirken.

Zur Steuerung der Härte der erfindungsgemäßen fotopolymerisierbaren Gemische und Elemente können allgemein aus der Kautschukverarbeitung bekannte Zusätze wie Weichmacher angewendet werden. Beispielsweise ergibt der Zusatz von als Weichmacher wirkenden Paraffinölen in bestimmten Mengen weichelastische Schichten mit gutem Rückstellverhalten, die als Unterschicht für mehrschichtige Flexoplatten eingesetzt werden können, wie sie in der DE-A-2 444 118 beschrieben sind. Zusätze von Oligomerstyrol, niedermolekularen Styrolcopolymerisaten, statistischen Styrol/Butadien-Copolymerisaten mit hohen Styrolgehalten und von α-Methylstyrol-Copolymerisaten erhöhen die Härte der belichteten Schichten.

Ferner können zur Steuerung der Belichtungseigenschaften Farbstoffe und photochrome Zusätze den photopolymerisierbaren Gemischen zugesetzt werden.

Die bekannte Oberflächenklebrigkeit, die beim Belichten von Schichten fotopolymerisierbarer, Acrylsäure- und Methacrylsäureester-enthaltender Gemische unter Sauerstoffzutritt auftritt, kann für die Verwendung der erfindungsgemäßen Gemische als Haftschicht ausgenutzt und durch geeignete Rezepturmischungen verstärkt werden. Als klebrigmachende Zusätze können handelsübliche Harze wie Kohlenwasserstoffharze, Kolophoniumester, Polyterpene, Cumaron-Inden-Harze u. ä. verwendet werden. Als vernetzende Monomere eignen sich dafür vorzugsweise di- oder polyfunktionelle Methacrylsäureester allein oder im Gemisch mit monofunktionellen Acrylsäureestern. Durch die fotochemische Vernetzung wird eine ausreichende Lösungsmittelstabilität erzielt, die für manche Verwendungen derartiger Haftschichten notwendig ist, z. B. für Reliefdruckformen, die in einem Auswaschprozeß mit Lösungsmitteln entwickelt werden.

Die erfindungsgemäßen Gemische zeichnen sich durch ihre gute Verarbeitbarkeit wie bei der Herstellung von Schichten aus. Die Gemische können mit bekannten Verfahren hergestellt und zu Schichten gewünschter Schichtdicke verarbeitet werden. Beispielsweise können Schichten der Gemische aus Lösungen in geeigneten Lösungsmitteln (wie Toluol, Xylol, Cylohexan, Tetrahydrofuran, Methylisobutylketon oder Tetrachloräthylen) durch Gießen auf entsprechende Schichtträger hergestellt werden, was dadurch gut möglich ist, daß sich die verwendeten Blockcopolymerisate in den erfindungsgemäßen Gemischen durch niedrige Lösungsviskositäten auszeichnen und leicht eine gute Homogenisierung der Gemischbestandteile in Lösung ermöglichen. Ebenso können derartige Schichten durch Pressen, Extrudieren und Kalandrieren hergestellt werden, wobei bei geeigneter Wahl der Inhibitoren keine thermische Anvernetzung zu befürchten ist.

Die Schichtstärke ist je nach Anwendungszweck leicht variabel, für fotopolymerisierbare Aufzeichnungselemente wie Druckplatten wird sie zwischen 0,01 und 6,5 mm Dicke variiert.

Als Schichtträger für lichthärtende Elemente eignen sich flexible Materialien (wie Metallplatten oder -folien, Folien aus Hochpolymeren wie Polyäthylenterephthalat, Polybutylenterephthalat, Polyamid, Polycarbonat) mit ausreichend hohem Elastizitätsmodul, um als dimensionsstabiles Trägermaterial für die spezielle Verwendung der Elemente geeignet zu sein. Die Auswahl der Schichtträger ist nicht auf Platten oder Folien begrenzt, ebenso können Gewebe oder Vliese wie Glasfasergewebe als Trägermaterialien dienen. Neben der dichten Verankerung der fotopolymerisierbaren Schicht auf einem Schichtträger hoher Festigkeit und Dimensionsstabilität können zur Erzielung höherer Plattendicken, wie sie beim Flexodruck in der Praxis durch die Benutzung konventioneller Gummiklischees vorgegeben sind, andere weichelastische Trägermaterialien eingesetzt werden, die ihrerseits mit einem dimensionsstabilen Schichtträger haftfest verbunden sind. Beispielsweise können für Mehrschichtverbundplatten weichelastische Unterschichten U eingesetzt werden, wie sie in der DE-A-2 444 118 beschrieben sind.

Für Druckplatten mit reliefbildenden Schichten von 3,0 mm bis 6,5 mm eignen sich besser einschichtige Platten, da in der Praxis bestimmte Montagetechniken üblich sind, bei denen die Druckplatte mittels einer Doppelklebefolie flach auf einen Montagebogen aufgeklebt und anschließend auf dem Druckzylinder einer Druckmaschine eingespannt wird. Zur Herstellung von Platten mit derartigen Schichtdicken werden beispielsweise Einzelschichten der fotopolymerisierbaren Materialien zusammenlaminiert unter Ausnutzung ihrer natürlichen Eigenklebrigkeit oder unter Verwendung von anlösenden Lösungsmitteln. Dabei können zur Erzielung besonderer Druckeigenschaften Schichten unterschiedlicher Härte und Rezepturen verwendet werden. Ebenso können mit Hilfe bekannter Techniken Schichten in einem Arbeitsgang extrudiert, kalandriert oder gepreßt werden.

Als Haftschichten zwischen Schichten der erfindungsgemäßen Gemische und Schichtträgern können handelsübliche Ein- oder Zweikomponentenkleber verwendet werden, deren Art sich nach dem Schichtträgermaterial und nach den aufgebrachten fotopolymerisierbaren Materialien und deren Rezeptur richtet. Als häufig geeignete Kleber seien die handelsüblichen Reaktionskleber auf Polyurethan- und auf Polychloropren-Basis genannt, die durch Substrieren oder Gießen in geeigneter Schichtdicke auf die zu verbindenden Schichten aufgebracht werden können.

Vorteilhaft sind auch lichthärtende Elemente mit einer Schicht aus dem erfindungsgemäßen Gemisch, die elastomere Unterschichten U gemäß der DE-A-2 444 118 mit einer Härte von 15 bis 70 Shore A und insbesondere von 25 bis 40 Shore A aufweisen, die kleiner oder gleich der Härte der fotopolymerisierbaren Schicht im fotovernetzten Zustand ist. Die Unterschicht U kann aus dem gleichen Basispolymeren wie die fotopolymerisierbare Schicht hergestellt sein, wobei durch entsprechende Weichmacherzusätze wie paraffinische und naphthenische Öle eine dem optimalen Druckverhalten angepaßte Härte eingestellt und die Unterschicht durch Totalbelichtung fotovernetzt wird. Daneben können für die Unterschicht andere geeignete elastomere Materialien eingesetzt werden. Im allgemeinen ist die Unterschicht U 0,5 bis 6 und insbesondere 1 bis 4 mm dick.

Für den Druckprozeß besonders geeignete Mehrschichtenplatten bzw. lichthärtbare Elemente weisen zwischen einer reliefbildenden Schicht aus dem erfindungsgemäßen Gemisch und einer weichelastischen Unterschicht U der vorgenannten Art eine Stabilisierungsschicht ST gemäß der DE-A-2 444 118 auf.

Es ist oft von Vorteil für lichthärtbare Elemente, auf die Schicht aus dem erfindungsgemäßen Gemisch noch eine haftfeste verbundene, dünne, klebfreie Überzugsschicht S aufzubringen, die bevorzugt aus einem harte, klebfreie, transparente und reißfeste Filme bildenden Polymeren, z. B. einem im Entwicklerlösungsmittel löslichen Polyamid, Copolyamid, Polyurethan oder Cyclokautschuk mit hohem Cyclisierungsgrad besteht. Die Stärke dieser Überzugsschicht beträgt zweckmäßigerweise etwa 0,5 bis 20 µm. Durch die Überzugsschicht S ist z. B. eine klebfreie, blasenfreie Negativauflage bei der Reliefdruckplattenherstellung möglich, die in manchen Fällen ohne diese wegen einer Oberflächenklebrigkeit der Schicht aus dem fotopolymerisierbaren Gemisch nicht möglich ist. Bei der Entwicklung der belichteten Anteile der Schicht zur Reliefschicht wird im allgemeinen die Überzugsschicht S mit den unvernetzten Schichtanteilen zusammen weggewaschen.

Es ist ferner oft vorteilhaft, die Überzugsschicht S noch mit einer abziehbaren Schutzfolie wie einer Polyesterfolie zu versehen, wobei diese auch zusammen mit der Überzugsschicht S auf die fotopolymerisierbare Schicht aufgebracht werden kann. Die Schutzfolie wird im allgemeinen vor der bildmäßigen Belichtung der Fotopolymerschicht abgezogen, während im allgemeinen die Überzugsschicht S dabei auf der Schicht verbleibt.

In an sich bekannter Weise können Schichten der erfindungsgemäßen Gemische durch Belichten in vernetzte bzw. unlösliche Formteile und z. B. durch bildmäßiges Belichten der Schicht und anschließendes Entfernen, insbesondere Auswaschen der unbelichteten bzw. unvernetzten Schichtanteile mit einem Entwicklerlösungsmittel zur Reliefformen verarbeitet werden, die für den Flexodruck besonders geeignet sind. Für die Belichtung, die in Form einer Flachbelichtung oder Rundbelichtung erfolgen kann, eignen sich die üblichen Lichtquellen von aktinischem Licht wie handelsübliche UV-Fluoreszenzröhren oder Quecksilberhochdrucklampen. Die emittierte Wellenlänge sollte bevorzugt bei 300 bis 400 mµ liegen bzw. auf die Eigenabsorption des in der fotopolymerisierbaren Schicht enthaltenen Fotoinitiaotrs abgestimmt sein. Beispiele geeigneter Entwicklerlösungsmittel für das Auswaschen der unvernetzten Anteile der Schicht zur Reliefentwicklung sind chlorierte Kohlenwasserstoffe, wie 1,1,1-Trichloräthan, sym. Tetrachloräthan, Tetrachloräthylen, Kohlenwasserstoffe, wie Hexan, Toluol oder andere organische Lösungsmittel wie Methylisobutylketon oder Mischungen solcher Lösungsmittel mit niederen Alkoholen zur Steuerung der Auswaschwirkung.

Die in den nachstehenden Beispielen genannten Teile und Prozente beziehen sich, soweit nicht anders angegeben, auf das Gewicht. Volumenteile verhalten sich zu Teilen wie Liter zu Kilogramm. Die angegebenen Viskositätszahlen (ml/g) wurden in Anlehnung an DIN 51 562 und DIN 53 726 bei 25°C mit 0,5gew.-%igen Lösungen der Polymeren in Toluol bestimmt. Die angegebenen Molekulargewichte $\overline{M}_v$ sind aus der Viskositätszahl ermittelte Gewichtsmittel.

Die Deformationshärte wurde bestimmt nach DIN 53 514.

Die Shore-A-Härte wurde ermittelt durch DIN 53 505.

Die Stoßprallelastizität wurde gemessen nach DIN 53 512.

Die Einfriertemperatur $T_G$ (second order transition point) wurde bestimmt nach DIN 53 520.

Die Reißdehnung wurde bestimmt gemäß DIN 53 504.

### Beispiel 1

Es wird verwendet ein Blockcopolymerisat ABC 1 mit 10% Polystyrol als Block A, 70% Polyisopren mit einer Einfriertemperatur $T_G$ von −53°C als Block B und 20% Polyisopren mit einem Gehalt von 53 Gew.-% 3,4-Konfiguration als Block C, der eine Einfriertemperatur $T_G$ von +10°C aufweist. Das Blockcopolymerisat ABC 1 hat eine Viskositätszahl von 164,9 ml/g, ein Gesamtmolekulargewicht $\overline{M}_v$ von 190 000, eine Deformationshärte von 4200/38 und eine Stoßelastizität von 53%.

440 Teile des Blockcopolymerisats ABC 1, stabilisiert mit 0,5% 2.6-Di-tert.butyl-p-kresol, 35 Teile Hexandiol-1,6-diacrylat, 6,5 Teile Benzildimethylketal und 0,04 Teile eines schwarzen Farbstoffs (C.I. 26 150, Solvent Black 3) werden in Toluol zu einer 50%igen Lösung gelöst und in solcher Schichtstärke auf eine Polyesterfolie aufgegossen, daß nach einstündigem Trocknen bei 80 bis 90°C ein Trockenfilm von 0,7 mm Dicke zurückbleibt. Die Polyesterfolie wurde zuvor mit einer ca. 2 µm dicken Schicht aus Cyclokautschuk mit hohem Cyclisierungsgrad beschichtet. Mit Hilfe dieser Beschichtung läßt sich die fotopolymerisierbare Schicht wieder von der Polyesterfolie abheben, wobei die Cyclokautschukschicht auf der Kautschukschicht verbleibt. Zur Verankerung auf einer Trägerschicht wird eine weitere Polyesterfolie mit einem handelsüblichen Polyurethan-Haftlack beschichtet und auf die freie Seite der fotopolymerisierbaren Schicht aufgewalzt.

Nach Abheben der ersten Polyesterfolie wird ein fotografisches Negativ aufgelegt und 10 Min. in einem handelsüblichen Flachbelichter (40-Watt-UV-Fluoreszenzlampen) unter Vakuumfolie bildmäßig belichtet. Zum Freilegen der vernetzten Reliefteile wird die belichtete Folienplatte in einem Sprühwascher mit einem Entwicklerlösungsmittelgemisch aus Tetrachloräthylen und n-Butanol (9 : 1 Vol.-Teile) ca. 5 Min. ausgewaschen, wobei die unbelichteten Schichtanteile herausgelöst werden. Die Druckform wird anschließend eine Stunde bei 80°C in einem Trockenschrank getrocknet. Die klebrige Oberfläche der Reliefteile wird in einer 0,4% wäßrigen Bromlösung 5 Min. nachbehandelt und anschließend 10 Min. in dem gleichen Belichter ohne Abdeckung nachbelichtet. Die Druckfolie wird mit Hilfe einer doppelseitigen Klebefolie auf einen Druckzylinder aufgeklebt. Die Oberfläche der Reliefdruckform ist klebfrei und nimmt die üblichen Flexodruckfarben ausgezeichnet an. Die erhaltenen Drucke zeigen eine exakte Wiedergabe der Vorlage mit randscharfen Details. Die Abriebfestigkeit, Quellung, Lösungsmittelresistanz und Elastizität der Druckform entspricht der herkömmlicher Gummiklischees.

Voll mit 30 Min. Belichtungszeit belichtete Folienproben haben eine Härte von 47 Shore A, eine Stoßelastizität von 48%. Die Reißdehnung war 341% bei einer Reißkraft von 9,2 N/mm². Der Elastizitätsmodul bei 100% Dehnung liegt bei 1,27 N/mm² (23°C).

### Beispiel 2

Eine Reliefdruckform von 2,0 mm Dicke für Flexodruckzwecke wird wie folgt hergestellt: Auf eine 0,125 mm dicke Polyesterträgerfolie, die mit einem handelsüblichen Zweikomponenten-Polyurethanhaftkleber beschichtet ist, wird eine 45%ige homogene, toluolische Lösung aus 400 Teilen eines Blockcopolymerisats ABC 2, 40 Teilen 1,6-Hexandiol-diacrylat, 35 Teilen 1,6-Hexandiol-dimethacrylat, 6 Teilen Benzildimethylketal, 0,04 Teilen des in Beispiel 1 genannten schwarzen Farbstoffs und 40 Teilen eines handelsüblichen α-Methylstyrol-Vinyltoluol-Copolymeren aufgerakelt und anschließend 90 Min. bei 80°C getrocknet. Die gleiche Lösung wird weiter auf eine mit Cyclokautschuk beschichtete Polyesterfolie wie in Beispiel 1 in gleicher Dicke aufgerakelt und ebenfalls getrocknet. Nach der Trocknung werden die beiden 1 mm dicken Schichten in einem Kaschierwerk zu einer 2,0 mm dicken Gesamtplatte zusammenkaschiert.

Das verwendete Blockcopolymerisat ABC 2 hat ein mittleres Molekulargewicht von 180 000 und eine Viskositätszahl von 170 (ml/g) und besteht aus 8% Polystyrol für Block A, 76% Polyisopren für Block B und 16% eines statistischen Copolymers aus gleichen Teilen Styrol und Butadien für Block C. Das Blockcopolymerisat hat eine Deformationshärte von 3900/45, eine Shore-A-Härte von 19 und eine Stoßelastizität von 63%. Die Einfriertemperatur des Blocks C beträgt −19°C.

Die unbelichtete Platte wird von der Plattenrückseite in einem Flachbelichter (s. Beispiel 1) 70 Sek. vorbelichtet. Anschließend wird die Polyesterdeckfolie der Plattenoberseite abgezogen und mit einem fotografischen Negativ 14 Min. durch eine über die Platte gezogene Vakuumfolie hindurch in dem gleichen Flachbelichter belichtet. Nach 10 Min. Auswaschen in einem handelsüblichen Sprühwascher mit einem Entwicklerlösungsmittelgemisch von Tetrachloräthylen/n-Butanol (9 : 1 Vol.Teile) und einstündigem Trocknen bei 80°C in einem Frischlufttrockenschrank wird eine Platte mit ca. 0,62 mm Reliefhöhe und 1,25 mm verbleibender, anpolymerisierter Unterschicht erhalten. Die weitere Plattenbehandlung erfolgt wie in Beispiel 1. Die erhaltene Druckplatte wurde mit Hilfe einer Doppelklebefolie auf einen Druckzylinder aufgespannt und mit einer handelsüblichen Flexodruckfarbe auf Basis Äthynol/Äthylacetat-Lösemitteln zu einem Auflagendruck von über 100 000 Auflagen verwendet. Die Platte zeigte ausgezeichnete Wiedergabegenauigkeit und Auflagenbeständigkeit.

Die Härte der Platte lag bei 42 Shore A, die belichtete Schicht hat eine Stoßelastizität von 61%, der Elastizitätsmodul bei 100% Dehnung liegt bei 1,19 N/mm², die Reißdehnung beträgt 423% und die Reißkraft 8,1 N/mm².

### Beispiel 3

Verwendet wird ein Blockcopolymerisat ABC 3 mit 15% Polystyrol als Block A, 75% Polyisopren als Block B und 10% eines statistischen Copolymerisats aus gleichen Teilen von Styrol und Isopren. Die Eintriertemperatur $T_G$ des Blocks C beträgt +5°C. Das Blockpolymerisat ABC 3 hat ein Molekulargewicht $\overline{M}_v$ von 130 000, eine Viskositätszahl von 122,3 ml/g, eine Deformationshärte von 3750/49 und eine Stoßelastizität von 64%.

Aus 64 Teilen des Blockcopolymerisats ABC 3, das mit 0,5% 2,6-Di-tert.butyl-p-kresol stabilisiert ist, 25 Teilen eines Paraffinöls, 5 Teilen 1,1,1-Trimethylolpropan-triacrylat, 5 Teilen 1,4-Butandiol-dimethacrylat, 1 Teil Benzildimethylketal und Toluol wird unter Erwärmen eine 60gew.-%ige Lösung hergestellt und mit einer Rakel auf eine analog Beispiel 1 mit einem Styrol-Maleinsäurehalbester-Copolymerisat beschichtete Polyesterfolie ausgegossen und glattgestrichen. Nach Trocknung der Schicht bei 80°C in einem Trockenschrank wird auf die ca. 2 mm dicke Schicht eine mit einem Zweikomponenten-Polyurethanhaftlack in 0,01 mm Dicke lackierte Polyesterfolie blasenfrei auflaminiert und 5 Min. in einem Flachbelichter (s. Beispiel 1) von dieser Seite belichtet. Der Sandwich eignet sich als elastomere Unterschicht für eine Mehrschichtenverbundplatte. Die Härte beträgt 25 Shore A, die Stoßelastizität 50%.

### Beispiel 4

Zur Herstellung einer Haftschicht mit hoher Klebrigkeit wird eine 10%ige toluolische Lösung von 100 Teilen des Blockcopolymerisats ABC 3, 75 Teilen eines handelsüblichen synthetischen Polyterpen-Harzes als klebrigmachendes Harz, 0,2 Teile 2,6-Di-tert.butyl-p-kresol, 15 Teilen 1,6-Hexandiol-diacrylat, 10 Teilen 1,6-Hexandiol-dimethacrylat und 2,5 Teilen Benzildimethylketal auf eine Polyesterfolie aufgegossen und das Toluol im Trockenschrank verdampft. Die 0,02 mm dicke Schicht wird 2 Min. in einem handelsüblichen Flachbelichter (s. Beispiel 1) belichtet und liefert eine sehr stark klebrige Haftschicht, die gute Haftung zur Trägerfolie zeigt.

Beispiel 5

Eine Mehrschichtenverbundplatte mit abgestufter Härteeinstellung von fotopolymerisierbarer Reliefschicht zur weichelastischen Unterschicht wird hergestellt aus einer fotovernetzten Unterschicht nach Beispiel 3 und einer reliefbildenden Schicht aus dem nachstehend genannten fotopolymerisierbaren Gemisch mit dem Blockcopolymerisat ABC 4.

Die Polyesterfolie der Unterschicht gemäß Beispiel 3, die bereits einseitig mit Haftlack beschichtet ist, wird auf der freien Seite ebenfalls mit einem Polyurethanhaftkleber in 10 μm Dicke beschichtet. Die Dicke dieser Polyesterfolie, die beidseitig mit Haftkleber beschichtet ist und als dimensionsstabile Folie zwischen reliefbildender Schicht und Unterschicht liegt, wird mit 75 μm gewählt.

Die reliefbildenden Schicht wird durch Auftragen einer Toluol-Lösung des folgenden fotopolymerisierbaren Gemisches auf eine mit Cyclokautschuk beschichtete 0,125 mm dicke Polyäthylenterephthalat-Folie hergestellt: 100 Teile eines Blockcopolymerisats ABC 4, stabilisiert mit 0,5% 2.6-Di-tert.butyl-p-kresol, 9,38 Teile eines handelsüblichen α-Methylstyrol-Vinyltoluol-Copolymerisats, 8,75 Teile 1,6-Hexandiol-diacrylat, 5,0 Teile 1,4-Butandiol-dimethacrylat, 1,5 Teile Benzildimethylketal, 0,01 Teile des in Beispiel 1 genannten schwarzen Farbstoffs. Das Blockcopolymerisat ABC 4 mit 8% Polystyrol als Block A, 76% Polybutadien als Block B und 16% eines statistischen Copolymeren aus gleichen Teilen Styrol und Butadien mit einer Einfriertemperatur $T_G$ von $-18°C$ als Block C hat ein Molekulargewicht $\overline{M}_v$ von 130 000, eine Viskositätszahl von 177, eine Deformationshärte von 6750/44, eine Shore-A-Härte von 37 und eine Stoßelastizität von 71%.

Zur Entfernung des Lösungsmittels aus der aufgetragenen Toluol-Lösung des fotopolymerisierbaren Gemisches wird 90 Min. bei 90°C im Frischlufttrockenschrank getrocknet. Die 0,7 mm dicke Schicht wird mit ihrer freien Seite auf die mit Haftlack beschichtete Seite der Unterschicht aufgewalzt. Der Sandwich wird zur Verbesserung der Reliefstruktur und breiteren Versockelung feiner Bildelemente durch die Unterschicht hindurch 40 Sek. in einem Flachbelichter (s. Beispiel 1) vorbelichtet. Die Belichtungszeit wird ermittelt, indem ein Probestreifen der Mehrschichtenverbundplatte in zeitlichen Stufen von je 5 Sek. bis 70 Sek. vorbelichtet wird und die Wirkung der Vorbelichtung auf die Reliefschicht durch Auswaschen derselben in der gleichen Weise wie bei der Entwicklung der bildmäßig belichteten Reliefschicht geprüft wird. Als geeignete Vorbelichtungszeit wird diejenige gewählt, bei der gerade noch keine anpolymerisierten Flächen der Reliefschicht zu sehen sind.

Anschließend wird die Polyesterdeckfolie der fotopolymerisierbaren Reliefschicht abgezogen und durch ein die Vorlage enthaltendes fotografisches Negativ 12 Min. in dem Flachbelichter belichtet. Das Negativ wird dabei durch die Vakuumfolie des Flachbelichters eng an die Plattenoberfläche angepreßt. Zur Entwicklung wird die belichtete Platte in einem handelsüblichen Sprühwascher bei 30°C mit einem Entwicklerlösungsmittelgemisch von Tetrachloräthylen/n-Butanol (9 : 1 Vol.-Teile) ausgewaschen. Trocknung, Nachbehandlung und Nachbelichtung erfolgen in gleicher Weise wie bei Beispiel 1.

30 Min. lang vollflächig belichtete Proben der fotopolymerisierbaren Reliefschicht haben eine Härte von 59 Shore A und eine Stoßelastizität von 75%. Der Modul bei 100% Dehnung liegt bei 2,15 N/mm², die Reißdehnung bei 310%, die Reißkraft hat 7,27 N/mm². Probedrucke dieser Druckplatte ergaben eine sehr gute Wiedergabe der Druckvorlage mit geringen Tonwertverschiebungen.

Beispiel 6

Für eine Mehrschichtenverbundplatte nach Beispiel 5 wird eine fotopolymerisierbare reliefbildende Schicht hergestellt auf der Basis eines Blockcopolymerisats ABC 5 mit 17% Polystyrol als Block A, 73% Polyisopren als Block B und 10% eines statischen Copolymerisats aus gleichen Teilen Isopren und Styrol (Einfriertemperatur $T_G = +6°C$). Das Blockcopolymerisat ABC 5 hat ein mittleres Molekulargewicht von 160 000, eine Viskositätszahl von 146,8 ml/g), eine Deformationshärte 4850/48, eine Shore-A-Härte von 25 und eine Stoßelastizität von 68%.

88 Teile des Blockcopolymerisats ABC 5 werden mit 11 Teilen Tripropylenglykoldiacrylat, 1 Teil Benzildimethylketal und 0,006 Teilen des in Beispiel 1 genannten schwarzen Farbstoffs in 100 Teilen Toluol bei 80°C gelöst und auf eine mit Cyclokautschuk beschichtete, 125 μm dicke Polyäthylenterephthalat-Trägerfolie (s. Beispiel 1) aufgegossen, so daß nach Trocknung bei 90°C über 1 Std. eine 0,7 mm dicke Trockenschicht verbleibt. Die Schicht wird dann in einem Kaschierwerk auf eine weichelastische Unterschicht aus Beispiel 3 aufkaschiert. Zuvor wird die freie Oberfläche der Polyesterfolie, die auf der anderen Seite bereits mit Haftkleber zur elastomeren Unterschicht beschichtet ist, mit dem gleichen Haftkleber lackiert. 30 Min. lang belichtete Proben der Schicht haben eine Shore-A-Härte von 48, eine Stoßelastizität von 60%, eine Reißdehnung von 307%, eine Reißkraft von 6,5 N/mm² und einen 100%-Modul von 1,65 N/mm². Die weitere Plattenherstellung erfolgt wie in Beispiel 5 angegeben.

# Patentansprüche

1. Fotopolymerisierbares Gemisch, enthaltend

a) wenigstens 40 Gew.-% mindestens eines in einem Entwicklerlösungsmittel löslichen elastomeren Blockcopolymerisats mit einem thermoplastischen nicht-elastomeren Polymerblock A und einem elastomeren Dien-Polymerblock B,

b) wenigstens 1 Gew.-% mindestens eines mit dem Blockcopolymerisat (a) verträglichen fotopolymerisierbaren olefinisch ungesättigten Monomeren und

c) 0,01 bis 10 Gew.-% mindestens eines Fotopolymerisationsinitiators,

dadurch gekennzeichnet, daß das Blockcopolymerisat (a) ein elastomeres Blockcopolymerisat der Struktur A-B-C ist, wobei

a1) der 5 bis 25 Gew.-% des Blockcopolymerisats ausmachende Polymerblock A aus mindestens einem der Styrol-Monomeren der Formel $CH_2=CRR'$ mit R = Wasserstoff oder Methyl, R' = Phenyl oder $C_1-C_4$-alkylsubstituiertes Phenyl hergestellt ist und eine Einfriertemperatur über +25°C hat,

a2) der 15 bis 90 Gew.-% des Blockcopolymerisats ausmachende Polymerblock B aus mindestens einem aliphatischen Dienkohlenwasserstoff mit 4 bis 5 C-Atomen hergestellt ist und eine Einfriertemperatur unter -20°C hat und

a3) der 5 bis 60 Gew.-% des Blockcopolymerisats ausmachende Polymerblock C durch Homo- oder Copolymerisation mindestens eines Dienkohlenwasserstoffs mit 4 bis 5 C-Atomen hergestellt ist und eine Einfriertemperatur zwischen -30°C und +15°C hat.

2. Fotopolymerisierbares Gemisch gemäß Anspruch 1, dadurch gekennzeichnet, daß der Polymerblock C mit dem Polymerblock A im Blockpolymerisat der Struktur ABC nicht verträglich ist.

3. Fotopolymerisierbares Gemisch gemäß Anspruch 1 oder 2, dadurch gekennzeichnet, daß im Blockcopolymersat A-B-C der Polymerblock C ein Polybutadien mit mehr als 70 Gew.-% 1,2-Konfiguration mit einem mittleren Molekulargewicht von 10 000 bis 90 000 ist.

4. Fotopolymerisierbares Gemisch gemäß Anspruch 1 oder 2, dadurch gekennzeichnet, daß im Blockcopolymerisat A-B-C der Polymerblock C ein Polyisopren mit mehr als 40 Gew.-% 3,4-Konfiguration mit einem mittleren Molekulargewicht von 10 000 bis 90 000 ist.

5. Fotopolymerisierbares Gemisch gemäß Anspruch 1 oder 2, dadurch gekennzeichnet, daß im Blockcopolymerisat A-B-C der Polymerblock C ein statisches Copolymerisat aus 70 bis 30 Gew.-% mindestens eines Dienkohlenwasserstoffs mit 4 bis 5 C-Atomen und 30 bis 70 Gew.-% mindestens eines Styrol-Monomeren der Formel $CH_2=CRR'$ mit R = Wasserstoff oder Methyl, R' = Phenyl oder $C_1-C_4$-alkylsubstituiertes Phenyl mit einer Einfriertemperatur zwischen -30°C und +15°C ist.

6. Fotopolymerisierbares Gemisch gemäß Anspruch 5, dadurch gekennzeichnet, daß der Polymerblock C 5 bis 35 Gew.-% des Blockcopolymerisats A-B-C ausmacht.

7. Fotopolymerisierbares Gemisch gemäß einem der Ansprüche 1 bis 6, dadurch gekennzeichnet, daß die Blockcopolymerisate A-B-C Viskositätszahlen von 60 bis 350 ml/g, gemessen als 0,5gew.-%ige Lösungen in Toluol bei 25°C, aufweisen.

8. Fotopolymerisierbares Gemisch gemäß einem der Ansprüche 1 bis 7, dadurch gekennzeichnet, daß ihm verträgliche klebrigmachende Harze zugemischt sind.

9. Fotopolymerisierbares Gemisch gemäß einem der Ansprüche 1 bis 7, dadurch gekennzeichnet, daß ihm Weichmacher zugemischt sind.

10. Lichthärtbare Elemente mit einer fotopolymerisierbaren Schicht auf einem Schichtträger, dadurch gekennzeichnet, daß die fotopolymerisierbare Schicht aus dem fotopolymerisierbaren Gemisch gemäß einem der Ansprüche 1 bis 9 besteht.

# Claims

1. A photopolymerizable composition which contains

a) not less than 40% by weight of at least one elastomeric block copolymer which is soluble in developer solutions and has a thermoplastic non-elastomeric polymer block A and an elastomeric diene polymer block B,

b) not less than 1% by weight of at least one photopolymerizable olefinically unsaturated monomer compatible with the block copolymer (a) and

c) from 0.1 to 10% by weight of at least one photopolymerization initiator,

wherein the block copolymer (a) is an elastomeric block copolymer having the structure A-B-C, in which

a1) the polymer block A, accounting for from 5 to 25% by weight of the block copolymer, is prepared from at least one styrene monomer of the formula $CH_2=CRR'$ where R is hydrogen or methyl and R' is phenyl or $C_1-C_4$-alkyl-substituted phenyl, and has a second order transition point above +25°C,

a2) the polymer block B which accounts for from 15 to 90% by weight of the block copolymer is prepared from at least one aliphatic diene hydrocarbon of 4 to 5 carbon atoms and has a second order transition point below −20°C, and

a3) the polymer block C which accounts for from 5 to 60% by weight of the block copolymer is prepared by homopolymerization or copolymerization of at least one aliphatic diene hydrocarbon of 4 or 5 carbon atoms, and has a second order transition point of from −30° to +15°C.

2. A photopolymerizable composition as claimed in claim 1, wherein the polymer block C is incompatible with the polymer block A in the block copolymer having the structure A-B-C.

3. A photopolymerizable composition as claimed in claim 1 or 2, wherein the polymer block C in the block copolymer A-B-C is a polybutadiene exhibiting more than 70% by weight of 1,2-configuration and having a mean molecular weight of from 10,000 to 90,000.

4. A photopolymerizable composition as claimed in claim 1 or 2, wherein the polymer block C in the block copolymer A-B-C is a polyisoprene exhibiting more than 40% by weight of 3,4-configuration and having a mean molecular weight of from 10,000 to 90,000.

5. A photopolymerizable composition as claimed in claim 1 or 2, wherein the polymer block C in the block copolymer A-B-C is a random copolymer which is prepared from 70 to 30% by weight of at least one diene hydrocarbon of 4 or 5 carbon atoms and from 30 to 70% by weight of at least one styrene monomer of the formula $CH_2 = CRR'$, where R is hydrogen or methyl and R′ is phenyl or $C_1 − C_4$-alkyl-substituted phenyl, and which has a second order transition point of from −30 to +15°C.

6. A photopolymerizable composition as claimed in claim 5, wherein the polymer block C accounts for from 5 to 35% by weight of the block copolymer A-B-C.

7. A photopolymerizable composition as claimed in any of claims 1 to 6, wherein the block copolymer A-B-C has an intrinsic viscosity of from 60 to 350 ml/g, measured on an 0.5% strength by weight solution in toluene at 25°C.

8. A photopolymerizable composition as claimed in any of claims 1 to 7, wherein compatible tackifying resins are admixed.

9. A photopolymerizable composition as claimed in any of claims 1 to 7, wherein plasticizers are admixed.

10. Photo-curable elements possessing a photopolymerizable layer on a base, wherein the photopolymerizable layer consists of a photopolymerizable composition as claimed in any of claims 1 to 9.

**Revendications**

1. Mélange photopolymérisable contenant:

a) au moins 40% en poids d'au moins un copolymérisat en blocs, élastomère, soluble dans un solvant révélateur, avec un bloc mère et un bloc polymère diène B élastomère;

b) au moins 1% en poids d'au moins un monomère à insaturation oléfinique, photopolymérisable, compatible avec le polymérisat en blocs (a);

c) 0,01 à 10% en poids d'au moins un initiateur de photopolymérisation,

caractérisé par le fait que le copolymérisat en blocs (a) est un copolymérisat en blocs élastomère, de structure A-B-C;

a1) le bloc polymère A, qui constitue 5 à 25% en poids du copolymérisat en blocs, étant préparé à partir d'au moins un styrène-monomère de formule $CH_2 = CRR'$, avec R = hydrogène ou méthyle, R′ = phényle ou phényle substitué par alkyle en $C_1 − C_4$ et ayant un point de transition du second ordre supérieur à +25°C;

a2) le bloc polymère B, qui constitue 15 à 90% du copolymérisat en blocs, étant préparé à partir d'au moins un hydrocarbure diénique aliphatique à 4 à 5 atomes C et ayant un point de transition du second ordre inférieur à −20°C; et

a3) le bloc polymère C, qui constitue 5 à 60% en poids du copolymérisat en blocs, étant préparé par homo-ou copolymérisation d'au moins un hydrocarbure diénique à 4 à 5 atomes C et ayant un point de transition du second ordre compris entre −30°C et +15°C.

2. Mélange photopolymérisable selon la revendication 1, caractérisé par le fait que le bloc polymère C n'est pas compatible avec le bloc polymère A dans le copolymère en blocs de structure A-B-C.

3. Mélange photopolymérisable selon la revendication 1 ou 2, caractérisé par le fait que, dans le copolymérisat en blocs A-B-C, le bloc polymère C est une polybutadiène, ayant plus de 70% en poids de configuration −1,2, avec un poids moléculaire moyen de 10 000 à 90 000.

4. Mélange photopolymérisable selon la revendication 1 ou 2, caractérisé par le fait que, dans le copolymérisat en blocs A-B-C, le bloc polymère C est un copolymère ayant plus de 40% en poids de configuration −3,4, avec un poids moléculaire moyen de 10 000 à 90 000.

5. Mélange photopolymérisable selon la revendication 1 ou 2, caractérisé par le fait que, dans le copolymérisat en blocs A-B-C, le bloc polymère C est un copolymérisat statistique de 70 à 30% en poids d'au moins un hydrocarbure diénique de 4 à 5 atomes C et 30 à 70% en poids d'au moins un styrène-monomère de formule $CH_2 = CRR'$, avec R = hydrogène ou méthyle, R′ = phényle ou phényle à substitution alkyle en $C_1 − C_4$, et d'un point de transition de second ordre compris entre −30°C et +15°C.

6. Mélange photopolymérisable selon la revendication 5, caractérisé par le fait que le bloc polymère C constitue 5 à 35% en poids du copolymérisat en blocs A-B-C.

7. Mélange photopolymérisable selon l'une des revendications 1 à 6, caractérisé par le fait que le copolymérisat en blocs A-B-C possède un chiffre de viscosité de 60 à 350 ml/g, mesuré sous forme de solutions à 0,5% en poids dans le toluène, à 25°C.

8. Mélange photopolymérisable selon l'une des revendications 1 à 7, caractérisé par le fait qu'on lui ajoute, par mélange, des résines compatibles conférant un état collant.

9. Mélange photopolymérisable selon l'une des revendications 1 à 7, caractérisé par le fait qu'on lui ajoute, par mélange, des plastifiants.

10. Eléments durcissables à la lumière, munis d'une couche photopolymérisable sur un substratum, caractérisés par le fait que la couche photopolymérisable est constituée d'un mélange photopolymérisable selon l'une des revendications 1 à 9.